# FASCICULE DE BREVET EUROPEEN

(11) **EP 1 243 024 B1**
(45) Date de publication et mention de la délivrance du brevet: **08.06.2011**
(21) Numéro de dépôt: 00993755.8
(22) Date de dépôt: 28.12.2000
(51) Int. Cl.: H01L 21/768

(54) **PROCEDE DE FORMATION D'UNE STRUCTURE D'INTERCONNEXIONS DONT L'ISOLANT INCLUT DES CAVITES**
HERSTELLUNGSVERFAHREN EINER VERBINDUNGSSTRUKTUR MIT EINER HOHLRÄUMEN-ENTHALDENDEN ISOLIERENDEN SCHICHT
METHOD OF MAKING INTERCONNECTION STRUCTURE WITH INSULATION COMPRISING CAVITIES

(30) Priorité: 29.12.1999 FR 9916637
(43) Date de publication de la demande: 25.09.2002
(73) Titulaire: Commissariat à l'Énergie Atomique et aux Énergies Alternatives, 75015 Paris (FR); STMicroelectronics S.A., 92120 Montrouge (FR)
(72) Inventeur: DEMOLLIENS, Olivier, F-38120 Saint-Egreve (FR); BERRUYER, Pascale, F-38410 Vaulnavey-le-Haut (FR); TROUILLER, Yorick, F-38000 Grenoble (FR); MORAND, Yves, F-38000 Grenoble (FR)
(74) Mandataire: Brykman, Georges
(86) Numéro de dépôt international: PCT/FR2000/003713
(87) Numéro de publication internationale: WO 2001/050524

(56) Documents cités:
- EP-A2- 0 710 981
- FR-A- 2 770 028
- JP-A- 9 306 988
- US-A- 5 559 055
- US-A- 5 953 626
- US-A- 6 043 145
- PATENT ABSTRACTS OF JAPAN vol. 1998, no. 14, 31 décembre 1998 (1998-12-31) & JP 10 233449 A (NEC CORP), 2 septembre 1998 (1998-09-02)

## Description

### Domaine technique

La présente invention concerne un procédé de réalisation d'une structure d'interconnexions de type Damascène sur un dispositif semiconducteur. La structure d'interconnexions comprend une isolation électrique associant du matériau de faible permittivité et des cavités d'air ou de vide.

### Etat de la technique antérieure

La réalisation de circuits intégrés de plus en plus denses nécessite la réalisation d'interconnexions de plus en plus performantes du point de vue résistance des lignes métalliques de connexion électrique et capacité des isolations intermétalliques. Pour diminuer cette résistance et cette capacité (diminution des délais RC et des effets de couplage parasite), il est nécessaire de faire évoluer les matériaux utilisés vers des matériaux métalliques de faible résistivité pour les éléments conducteurs et vers des matériaux diélectriques de faible constante diélectrique pour les éléments isolants. Ainsi, l'aluminium tend à être remplacé par le cuivre et les matériaux diélectriques classiquement utilisés tels que SiO₂, SiₓN_{y}, SiOₓN_{y} tendent à être remplacés par des matériaux de type dopé au fluor (FSG par exemple), méthylsilsesquioxane (MSQ), hydrogène silsesquioxane (HSQ), organique (BCB, SilK, Flare, PAE, etc), poreux (NanoGlass par exemple), etc. Pour les matériaux diélectriques, la limite ultime est l'utilisation du vide ou de l'air. C'est la maîtrise de cette isolation ultime qui pose actuellement problème.

L'utilisation de l'air ou du vide comme isolant ultime pour interconnexions est décrite dans l'article "A Novel Air Gap Intégration Scheme for Multi-level Interconnects using Self-aligned Via Plugs" de T. UEDA et al., paru dans 1998 Symposium on VLSI Technology Digest of Technical Papers (IEEE 1998). Ce document divulgue l'utilisation de procédés de dépôt de diélectrique à faible capacité de remplissage ou mauvaise conformité. Cette technique s'applique à la réalisation d'interconnexions conventionnelles, les lignes et les plots de métal étant réalisés par dépôt de métal tel que l'aluminium ou le tungstène, le métal déposé étant ensuite gravé. Elle est donc incompatible avec des interconnexions en cuivre, métal difficile à graver.

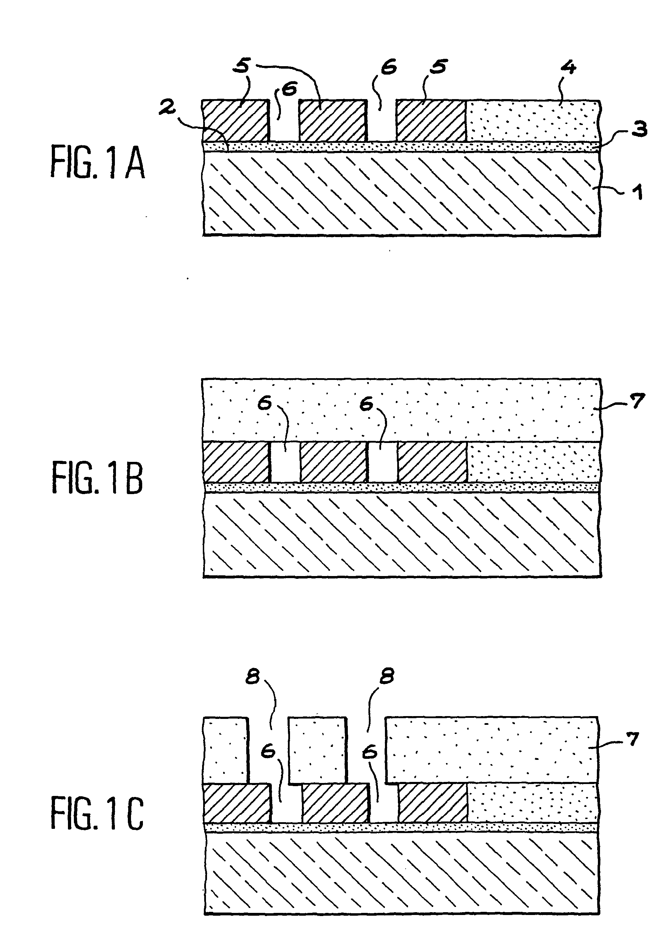

Le document EP-A-0 834 916 divulgue également l'utilisation de cavités d'air pour réaliser une structure d'interconnexions à performances améliorées (structure Damascène). La technique divulguée par ce document n'est cependant pas utilisable lorsque la structure comporte des vias débordants, c'est-à-dire des interconnexions dans lesquelles les plots (ou vias) métalliques reliant un métal de niveau n au métal de niveau supérieur n + 1 peuvent être de taille plus grande que les lignes de métal de niveau n ou positionnés à cheval sur le métal de niveau n. En effet, dans ce cas, qui va être illustré par les figures 1A à 1C, les cavités d'air ou de vide sont réalisées avant la gravure des trous qui vont permettre de connecter le métal de niveau n au métal de niveau n + 1. Ces trous vont donc déboucher sur des cavités, ce qui rend impossible par la suite leur remplissage par un métal.

La figure 1A représente une structure simple Damascène de l'art connu formée sur une face 2 d'un substrat semiconducteur 1. La face 2 est recouverte d'une première couche de matériau diélectrique 3, elle-même recouverte d'une deuxième couche de matériau diélectrique 4 destinée à loger des lignes de cuivre 5. Le procédé de réalisation a laissé subsister des cavités 6 destinées à renfermer de l'air.

Une troisième couche de matériau diélectrique 7 est déposée sur la structure en laissant subsister les cavités 6 de petites dimensions. C'est ce que montre la figure 1B.

La figure 1C montre la structure après que des trous 8 pour le logement de vias qui s'avèrent être des vias débordants ont été réalisés dans la couche de matériau diélectrique 7. Les trous 8 posent problème du fait qu'ils débouchent sur les cavités. Leur remplissage pour réaliser les vias débordants, surtout, pose problème

Le document EP-A-0 834 916 divulgue également la réalisation d'isolation électrique par des matériaux diélectriques à faible permittivité (inférieure à 2,7) pour des structures d'interconnexions de type Damascène. Les interconnexions sont d'abord réalisées avec un isolant de permittivité inférieure à 3,5 qui est ensuite éliminé et remplacé par un isolant de permittivité inférieure à 2,7 (choisi parmi HSQ, BCB, un polyimide et PAE). Ce procédé de réalisation pose des problèmes de planarisation importants : bonne planarisation des régions à forte densité de métal, mauvaise planarisation des lignes métalliques isolées. En outre, ce procédé fait perdre tout l'avantage procuré par la technologie Damascène.

Le document US-A-5 953 626 divulgue un procédé de fabrication d'une structure d'interconnexions de type Damascène à deux niveaux d'interconnexions et comprenant une isolation électrique par de l'air. La variante de réalisation illustrée par la figure 10 concerne une structure où le matériau diélectrique initial a été complètement éliminé et n'a pas été remplacé, l'air servant de diélectrique. La variante de réalisation illustrée par la figure 14 concerne une structure où le matériau diélectrique initial a aussi été complètement éliminé et n'a pas été remplacé. Par contre, les interconnexions sont protégées de l'environnement par une couche de passivation déposée sur la structure avant élimination du matériau diélectrique et par une couche de fermeture obstruant les ouvertures pratiquées dans la couche de passivation pour éliminer le matériau diélectrique.

Le document US-A-5 559 055 divulgue un procédé de fabrication d'une structure d'interconnexions de type Damascène à deux niveaux d'interconnexions. Le premier niveau d'interconnexions comprend un matériau diélectrique autre que l'air entre les interconnexions. Le deuxième niveau d'interconnexions peut comprendre de l'air entre les interconnexions (voir la figure 5b). Les cavité d'air sont réalisées dans le deuxième niveau de la structure.

Le document FR-A-2 770 028 divulgue un procédé de fabrication d'une structure d'interconnexions pour un dispositif à circuit intégré. De l'air est utilisé comme diélectrique entre conducteurs. La figure 9 montre une structure d'interconnexions réalisée sur un substrat semiconducteur recouvert d'un diélectrique inter-couche. La structure comprend des conducteurs de premier niveau, reliés par des bouchons de tungstène à des conducteurs de connexion. La structure comprend aussi une couche d'oxyde de recouvrement, une couche d'arrêt et un diélectrique inter-métal. De l'air remplace une couche de carbone initialement déposée sur le diélectrique (voir la figure 7). La couche de carbone et les conducteurs de premier niveau sont recouverts d'abord de la couche d'oxyde. Le carbone est alors éliminé par incinération. Pour cela, le dispositif est placé dans une ambiance d'oxygène à une température d'environ 400-450°C. Dans cet environnement, l'oxygène diffuse à travers la couche d'oxyde pour réagir avec le carbone en formant du CO₂ qui diffuse à son tour au travers de la couche et s'échappe. Il en résulte des cavités de gaz désigné comme étant de l'air.

Le document JP-A-10 233 449 divulgue un procédé de réalisation d'une structure d'interconnexions comprenant une isolation électrique incluant des cavités d'air. Un premier niveau de conducteurs recouvre une face d'un substrat. Ce premier niveau de conducteurs est noyé dans une couche isolante. Des trous sont pratiqués dans la couche isolante jusqu'à révéler certains conducteurs. Dans ces trous sont déposés une barrière métallique et des conducteurs de deuxième niveau. La couche isolante est éliminée. Une nouvelle couche isolante est alors formée. Cette couche noie les conducteurs de premier niveau et de deuxième niveau en laissant subsister des cavités d'air. Le surplus d'isolant est ensuite éliminé pour révéler les conducteurs de deuxième niveau.

### Exposé de l'invention

La présente invention a été conçue pour remédier aux problèmes exposés ci-dessus. Elle permet la réalisation d'isolations électriques pour des interconnexions métalliques réalisées en technologie Damascène comprenant une combinaison de cavités (renfermant de l'air ou du vide), de matériaux diélectriques de faible permittivité (inférieure à 3) et de matériaux de type SiO₂, SiₓN_{y}, SiOₓN_{y}, SiOF. Ces isolations électriques sont compatibles avec des plots de métal reliant un métal de niveau n au métal de niveau n + 1, ces plots de métal pouvant être de taille plus grande que les lignes de métal de niveau n ou positionnés à cheval sur le métal de niveau n et le diélectrique adjacent. Ce procédé permet également une parfaite planarisation des interconnexions.

L'invention a donc pour objet un procédé de réalisation d'une structure d'interconnexions de type Damascène telle que mentionnée dans la revendication 1.

Des variantes de réalisation sont décrites dans les revendications dépendantes.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1C, déjà décrites, sont des vues en coupe transversale d'une structure d'interconnexions de type Damascène, selon l'art connu, en cours de réalisation,
- les figures 2A à 2F sont des vues en coupe transversale d'une structure d'interconnexions de type Damascène en cours de réalisation, selon un premier mode de mise en oeuvre ce mode ne formant pas partie de l'invention mais étant nécessaire pour la comprendre,
- les figures 3A à 3D sont des vues en coupe transversale d'une structure d'interconnexions de type Damascène en cours de réalisation, selon un mode de mise en oeuvre de l'invention,
- les figures 4A à 4C sont des vues en coupe transversale d'une structure d'interconnexions de type Damascène à vias débordants et en cours de réalisation, selon le premier mode de mise en oeuvre, lequel n'est pas partie de l'invention.

### Description détaillée de modes de mise en oeuvre de l'invention

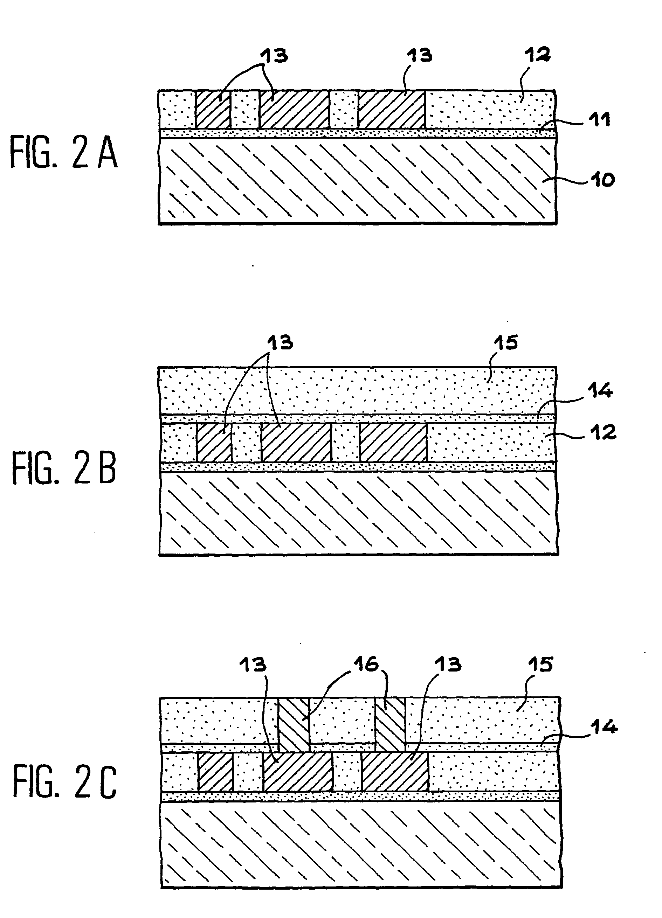

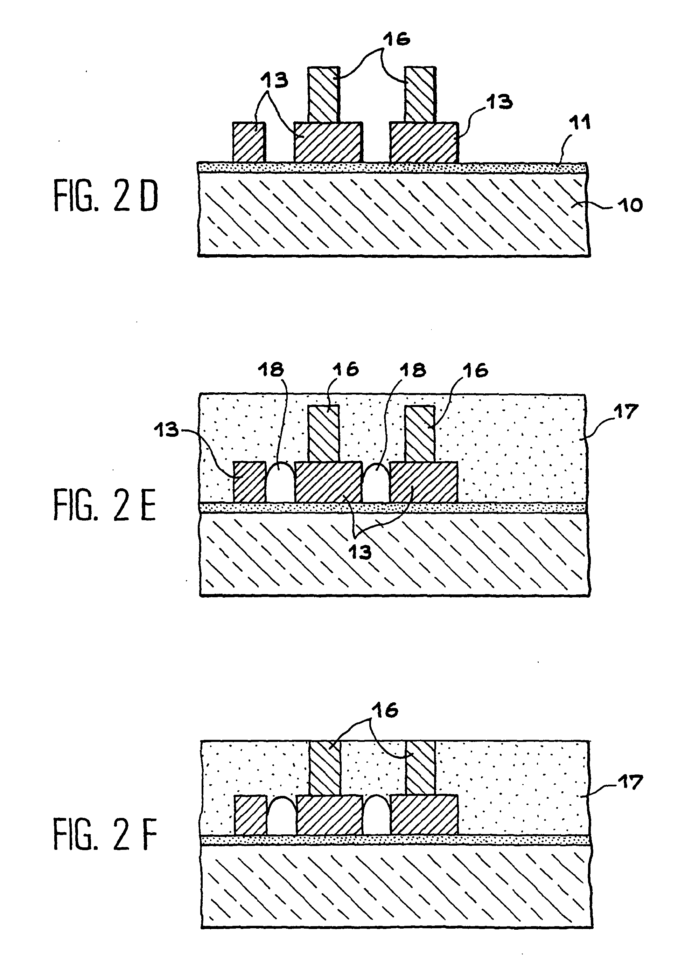

Les figures 2A à 2F illustrent un premier mode de mise en oeuvre à partir d'un substrat en silicium.

La figure 2A montre un substrat 10 en silicium recouvert d'une couche d'interface 11 par exemple en SiₓN_{y}, en SiOₓN_{y} ou en SiC et d'une première couche d'isolation électrique 12 par exemple en SiO₂ ou en SiOF. Les couches 11 et 12 peuvent être déposées par des techniques bien connues de l'homme de l'art. De manière également bien connue, des lignes conductrices 13, par exemple en cuivre, sont formées dans la première couche d'isolation électrique 12. L'écartement entre les lignes conductrices 13, ou du moins entre certaines lignes conductrices 13, est prévu pour permettre, dans une étape ultérieure, la formation de cavités d'air ou de vide entre ces lignes.

Comme le montre la figure 2B, une couche d'interface 14, par exemple en SiₓN_{y}, en SiOₓN_{y} ou en SiC, est déposée sur la première couche d'isolation électrique 12 intégrant les lignes conductrices 13. Sur la couche d'interface 14, on dépose une deuxième couche d'isolation électrique 15 par exemple en SiO₂ ou en SiOF. Ces dépôts de couches sont effectués par des méthodes bien connues de l'homme de l'art.

Des vias conducteurs 16, par exemple en cuivre, sont alors formés au travers de la deuxième couche d'isolation électrique 15 et de la couche d'interface 14. Les vias conducteurs 16 assurent ainsi une liaison électrique avec des lignes conductrices 13.

Les lignes conductrices et les vias conducteurs peuvent comporter des couches barrières, par exemple en TiN, Ta, TaN, W, WN.

Selon ce premier mode de mise en oeuvre de l'invention, la deuxième couche d'isolation électrique 15, la couche d'interface 14 et la première couche d'isolation électrique 12 sont éliminées. On obtient la structure représentée à la figure 2D.

Sur cette structure, on dépose un matériau diélectrique 17 à faible permittivité, matériau dit low-k (permittivité inférieure à 3) : par exemple un polymère, du SiOC, un matériau diélectrique poreux (par exemple un matériau de marque Nanoglass), du HSQ. Le matériau 17 peut être déposé par étalement ou par voie chimique en phase vapeur (CVD). Il peut s'agir dans ce cas d'un matériau à forte viscosité, d'un polymère à chaîne monomère longue. On peut également utiliser des procédés de dépôt adaptés (PECVD, etc.) qui laissent des cavités dans les espaces intermétalliques de faibles dimensions. La figure 2E représente cette étape du procédé et montre notamment la présence de cavités 18 entre des lignes conductrices 13. Cette figure montre également que les vias conducteurs 16 sont recouverts par le matériau diélectrique 17.

On applique alors un procédé de gravure ou de polissage mécano-chimique (CMP) pour éliminer le matériau diélectrique 17 en excès et révéler les vias 16 ainsi que pour planariser la structure. Cette planarisation est d'autant plus facile à réaliser qu'elle ne concerne que du matériau diélectrique.

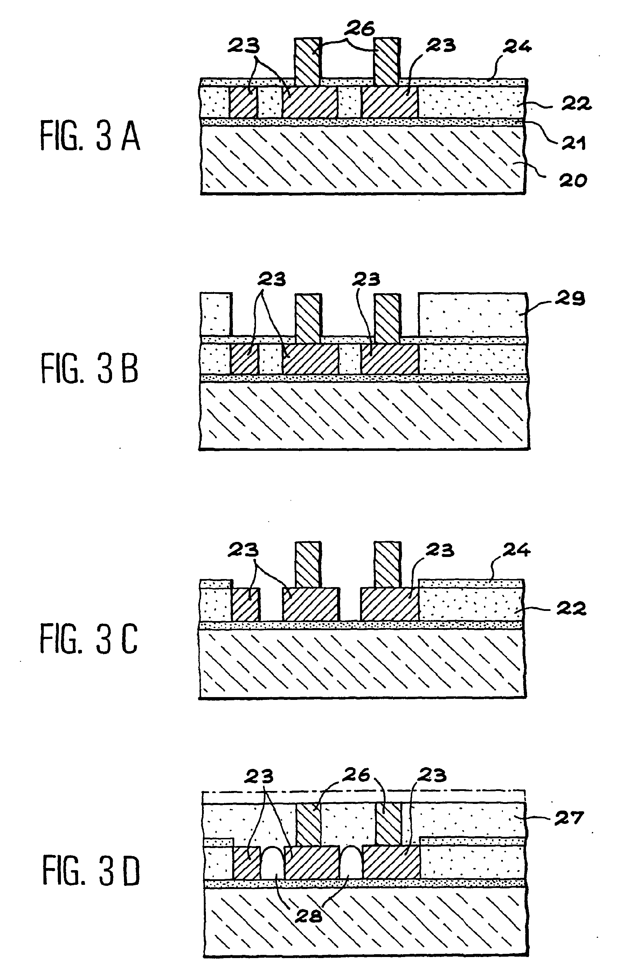

Les figures 3A à 3D illustrent un mode de mise en oeuvre de l'invention à partir d'un substrat en silicium.

Les premières étapes de ce deuxième mode de mise en oeuvre sont identiques à celles illustrées par les figures 2A à 2C. Elles ne seront donc pas représentées.

La figure 3A montre la structure obtenue après le retrait de la deuxième couche d'isolation électrique En variante, la couche d'interface située entre les deux couches d'isolation électrique pourrait également être retirée. Le substrat 20 supporte une couche d'interface 21, elle-même recouverte de la première couche d'isolation électrique 22 intégrant les lignes conductrices 23. La couche d'interface 24 recouvre ce premier niveau de conducteurs, les vias conducteurs 26 assurant la liaison électrique avec des lignes conductrices 23.

Une couche de résine photosensible est alors déposée sur la structure pour former, par lithographie, un masque 29 protégeant les zones où les écartements entre les lignes 23 sont larges, par exemple supérieurs à 0,5 µm (voir la figure 3B).

Les zones de la couche d'interface 24 et de la première couche d'isolation électrique 22 non protégées par le masque de résine 29 sont éliminées. Ces zones correspondent aux endroits de la structure où les lignes conductrices 23 sont faiblement écartées (par exemple d'écartement inférieur à 0,5 µm). Le résultat obtenu est illustré par la figure 3C.

Sur cette structure, on dépose un matériau diélectrique 27 à faible permittivité et à faible capacité de remplissage. Il se forme alors, comme le montre la figure 3D, des cavités 28 entre les lignes conductrices 23 faiblement écartées. Les vias conducteurs 26, initialement recouverts par le matériau diélectrique 27 dont le niveau supérieur est représenté en traits mixtes, sont exposés à la suite d'un procédé de gravure ou de polissage mécano-chimique de l'excès du matériau diélectrique 27.

Dans le cas de ce deuxième mode de mise en oeuvre de l'invention, il n'est pas nécessaire que l'élimination du matériau diélectrique en excès soit planarisant. En effet, le fait de laisser la première couche d'isolation électrique 22 dans les zones métalliques non denses permet de garder une bonne planéité de la structure après le dépôt du matériau diélectrique 27 à faible permittivité. Lors du dépôt du matériau diélectrique 27, la structure est déjà quasi plane hormis les vias conducteurs 26 qui dépassent légèrement et les petits espaces intermétalliques. La planarisation en est grandement facilitée

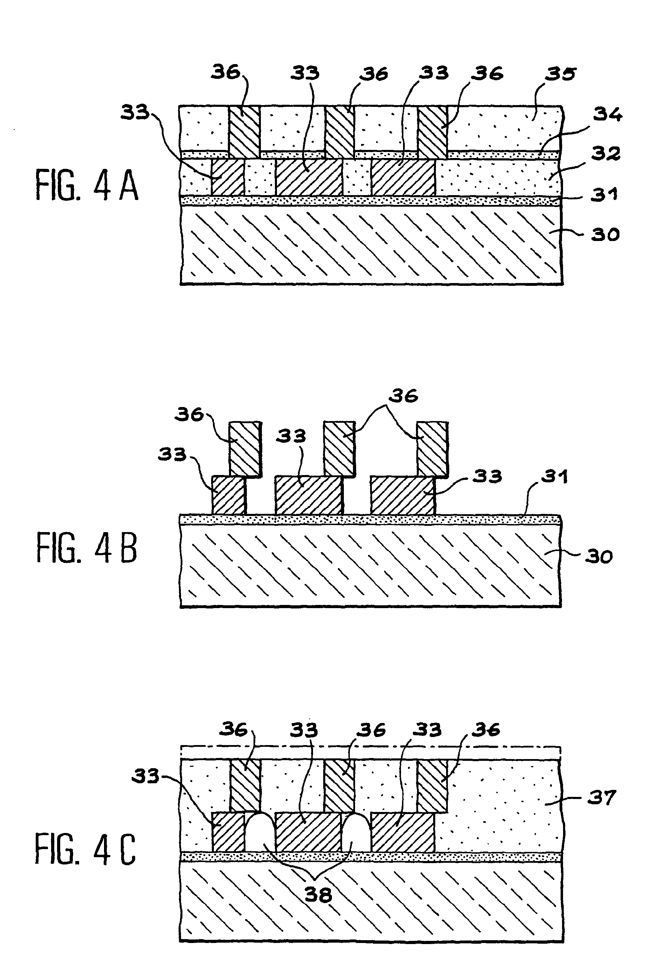

Les figures 4A à 4C illustrent la - réalisation d'une structure d'interconnexions de type Damascène à vias débordants, selon le premier mode de mise en oeuvre.

Les premières étapes du procédé de réalisation sont identiques à celles illustrées par les figures 2A à 2C, à l'exception de la position des vias. La structure obtenue à ce stade est celle représentée à la figure 4A. Le substrat 30 supporte une couche d'interface 31, elle-même recouverte de la première couche d'isolation électrique 32 intégrant les lignes conductrices 33. La couche d'interface 34 recouvre ce premier niveau de conducteurs et supporte la deuxième couche d'isolation électrique 35 intégrant les vias conducteurs 36 assurant la liaison électrique avec des lignes conductrices 33.

Conformément au premier mode de mise en oeuvre, la deuxième couche d'isolation électrique 35, la couche d'interface 34 et la première couche d'isolation électrique 32 sont éliminées. On obtient la structure représentée à la figure 4B.

Sur cette structure, on dépose un matériau diélectrique 37 à faible permittivité et à faible capacité de remplissage. Il se forme alors, comme le montre la figure 4C, des cavités 38 entre les lignes conductrices 33 faiblement écartées. Les vias débordants 36, initialement recouverts par le matériau diélectrique 37 dont le niveau supérieur est représenté en traits mixtes, sont exposés à la suite d'un procédé de gravure ou de polissage mécano-chimique de l'excès de matériau diélectrique 37.

L'invention permet donc la réalisation de structures à vias débordants puisque la formation des cavités est réalisée après la réalisation des vias.

Entre autres avantages, l'invention permet :
- la réalisation d'isolations intermétalliques comprenant à la fois du vide ou de l'air, des matériaux diélectriques à faible permittivité (inférieure à 3) et des diélectriques de type minéral (SiOₓ, SiₓN_{y}, SiOₓN_{y}, SiOF, ...) ;
- la compatibilité de cette isolation avec la réalisation de trous de contact désalignés par rapport au métal sous-jacent (vias débordants) ;
- l'obtention de cavités de vide ou d'air dans les zones où les espaces intermétalliques sont les plus petits (par exemple inférieurs à 0,5 µm), c'est-à-dire là où il est réellement nécessaire d'avoir un matériau diélectrique à très faible permittivité tout en conservant un diélectrique à faible permittivité dans les autres régions ;
- la réalisation d'isolations intermétalliques en laissant un diélectrique minéral (par exemple SiO₂, SiOF,...) dans les zones où les espaces intermétalliques sont larges (par exemple supérieurs à 0,5 µm), ce qui facilite le dépôt du diélectrique à très faible permittivité (plus de problème de planarisation puisque seuls les vias dépassent), améliore la tenue mécanique de l'isolant (compte tenu de la meilleure tenue mécanique des diélectriques de type minéral par rapport aux matériaux carbonés) et améliore le comportement du dispositif du point de vue dissipation thermique (meilleurs conductibilité thermique des diélectriques minéraux par rapport aux matériaux à très faible permittivité de façon générale).

## Revendications

1. Procédé de réalisation d'une structure d'interconnexions de type Damascène sur un dispositif semiconducteur (20), la structure d'interconnexions comprenant au moins un premier niveau de conducteurs électriques (23) recouvert par un deuxième niveau de conducteurs électriques (26) assurant des liaisons électriques avec les conducteurs électriques du premier niveau, la structure d'interconnexions comprenant une isolation électrique (27) comprenant du matériau de permittivité électrique inférieure à 3 et des cavités (28) d'air ou de vide situées entre des conducteurs électriques du premier niveau de conducteurs électriques, le procédé comprenant les étapes successives suivantes :
- dépôt, sur le dispositif semiconducteur (20), d'une première couche d'isolation électrique (22),
- formation du premier niveau de conducteurs électriques (23) dans la première couche d'isolation électrique (22), certains des conducteurs électriques du premier niveau étant disposés avec un écartement faible prévu pour permettre, dans une étape ultérieure, la formation des cavités (28) d'air ou de vide entre eux,
- dépôt, sur la première couche d'isolation électrique (22), d'une deuxième couche d'isolation électrique
- formation du deuxième niveau de conducteurs électriques (26) dans la deuxième couche d'isolation électrique, assurant lesdites liaisons électriques avec les conducteurs électriques du premier niveau,
- élimination de la deuxième couche d'isolation électrique
- élimination de la première couche d'isolation électrique (22) pour éliminer les parties de la première couche d'isolation électrique correspondant aux zones où lesdits conducteurs électriques ont ledit écartement faible, en laissant la première couche d'isolation électrique dans les zones où l'écartement entre les conducteurs électriques du premier niveau est large,
- dépôt, sur la structure obtenue, du matériau de permittivité électrique inférieure à 3 27), ce dépôt ne comblant pas l'espace entre des conducteurs électriques du premier niveau dont l'écartement a été prévu pour permettre la formation de cavités d'air ou de vide (28).

2. Procédé selon la revendication 1, **caractérisé en ce que** le dépôt de matériau de permittivité électrique inférieure à 3 recouvrant les conducteurs électriques du deuxième niveau, le procédé comprend, après l'étape de dépôt du matériau de permittivité électrique inférieure à 3, une étape de planarisation pour révéler ces conducteurs électriques.

3. Procédé selon l'une des revendications 1 ou 2, **caractérisé en ce que** la première couche d'isolation électrique (22) est une couche d'un matériau choisi parmi SiO₂ et SiOF.

4. Procédé selon l'une quelconque des revendications 1 ou 3, **caractérisé en ce que** la deuxième couche d'isolation électrique est une couche d'un matériau choisi parmi SiO₂ et SiOF.

5. Procédé selon l'une quelconque des revendications 1 à 4, **caractérisé en ce qu'**il comprend le dépôt d'une première couche d'interface en matériau isolant (21) sur le dispositif semiconducteur (20) avant la formation du premier niveau de conducteurs électriques, et le dépôt d'une deuxième couche d'interface (24) sur le premier niveau de conducteurs électriques avant la formation du deuxième niveau de conducteurs électriques.

6. Procédé selon la revendication 5, **caractérisé en ce que** le matériau isolant de la première couche d'interface (21) est choisi parmi SiₓN_{y}, SiOₓN_{y} et SiC.

7. Procédé selon l'une des revendications 5 ou 6, **caractérisé en ce que** la deuxième couche d'interface (24) est en un matériau choisi parmi SiₓN_{y}, SiOₓN_{y} et SiC.

8. Procédé selon l'une quelconque des revendications 5 à 7, **caractérisé en ce qu'**il comprend, après l'élimination de la deuxième couche d'isolation électrique et avant l'étape d'élimination de la première couche d'isolation électrique (22), le dépôt d'une couche de résine sur la couche d'interface déposée sur le premier niveau de conducteurs électriques, la formation d'un masque (29) à partir de la couche de résine pour réaliser l'élimination de la première couche d'isolation électrique (22), l'élimination de la partie de la couche d'interface (24) déposée sur le premier niveau de conducteurs électriques et non masquée par le masque de résine, l'étape d'élimination de la première couche d'isolation électrique étant alors réalisée.

9. Procédé selon l'une quelconque des revendications 1 à 8, **caractérisé en ce que** les conducteurs électriques du premier niveau de conducteurs électriques et les conducteurs électriques du deuxième niveau de conducteurs électriques sont en cuivre ou comprennent du cuivre.

## Claims

1. A method for making a damascene type structure of interconnections on a semiconductor device (20), with the structure of interconnections comprising at least a first level of electric conductors (23) covered with a second level of electric conductors (26) ensuring electric connections with the electric conductors of the first level, the structure of interconnections comprising an electric insulation (27) comprising material with an electric permittivity of less than 3 and air or vacuum cavities (28), located between electric conductors of the first level of electric conductors, with the method comprising the following, successive steps:
- deposition on the semiconductor device (20) of a first electric insulation layer (22),
- formation of the first level of electric conductors (23) in the first electric insulation layer (22), some of the electric conductors of the first level being arranged with a small spacing provided for allowing, in a subsequent step, the formation of air or vacuum cavities (28) between them,
- deposition on the first electric insulation layer (22) of a second electric insulation layer,
- formation of the second level of electric conductors (26) in the second electric insulation layer, ensuring said electric connections with the electric conductors of the first level,
- elimination of the second electric insulating layer,
- elimination of the first electric insulating layer (22) in order to eliminate the parts of the first electric insulation layer corresponding to the areas where said electric conductors have said small spacing, while leaving the first electric insulation layer in the areas where the spacing between the electric conductors of the first level is wide,
- deposition, over the obtained structure, of the material (27) with an electric permittivity of less than 3, with this deposit not filling the space between electric conductors of the first level, the spacing of which has been provided for allowing the formation of air or vacuum cavities (28).

2. The method according to claim 1, **characterized in that**, the deposit of material with an electric permittivity of less than 3 covering the second level electric conductors, the method comprises, after the step for depositing the material with an electric permittivity of less than 3, a planarization step in order to reveal these electric conductors.

3. The method according to one of claims 1 or 2, **characterized in that** the first electric insulating layer (22) is a layer of a material selected from SiO₂ and SiOF.

4. The method according to any of claims 1 or 3, **characterized in that** the second electric insulating layer is a layer of a material selected from SiO₂ and SiOF.

5. The method according to any of claims 1 to 4, **characterized in that** it comprises the deposition of a first interface layer (21) of an insulating material on the semiconductor device (20) before the formation of the first level of electric conductors, and the deposition of a second interface layer (24) on the first level of electric conductors before the formation of the second level of electric conductors.

6. The method according to claim 5, **characterized in that** the insulating material of the first interface layer (21) is selected from SiₓN_{y}, SiOₓN_{y} and SiC.

7. The method according to one of claims 5 or 6, **characterized in that** the second interface layer (24) is in a material selected from SiₓN_{y}, SiOₓN_{y} and SiC.

8. The method according to any of claims 5 to 7, **characterized in that** it comprises, after the elimination of the second electric insulating layer and before the step for eliminating the first electric insulating layer (22), the deposition of a layer of resin on the interface layer deposited on the first level of electric conductors, the formation of a mask (29) made from the resin layer for achieving elimination of the first electric insulation layer (22), the elimination of the part of the interface layer (24) deposited on the first level of electric conductors and not masked by the resin mask, the step for eliminating the first electric insulation layer having then been achieved.

9. The method according to any of claims 1 to 8, **characterized in that** the electric conductors of the first level of electric conductors and the electric conductors of the second level of electric conductors are in copper or comprise copper.

## Patentansprüche

1. Verfahren zur Herstellung einer Verbindungsstruktur vom Damaszener-Typ auf einem Halbleiterbauteil (20), wobei die Verbindungsstruktur wenigstens eine erste Ebene elektrischer Leiter (23) umfasst, die von einer zweiten Ebene elektrischer Leiter (26) abgedeckt ist, was elektrische Verbindungen mit den elektrischen Leitern der ersten Ebene sicher stellt, wobei die Verbindungsstruktur eine elektrische Isolierung (27) umfasst, die ein Material mit einer elektrischen Permittivität von kleiner als 3 und luftgefüllte oder leere Hohlräume (28) umfasst, die sich zwischen den elektrischen Leitern der ersten Ebene elektrischer Leiter befinden, das Verfahren umfassend die folgenden sukzessiven Schritte:
- Aufbringen einer ersten elektrischen Isolationsschicht (22) auf dem Halbleiterbauteil (20),
- Bilden der ersten Ebene elektrischer Leiter (23) in der ersten elektrischen Isolationsschicht (22), wobei einige der elektrischen Leiter der ersten Ebene mit einem geringen Abstand angeordnet werden, der vorgesehen ist, um in einem späteren Schritt die Bildung der luftgefüllten oder leeren Hohlräume (28) zwischen diesen zu ermöglichen;
- Aufbringen einer zweiten elektrischen Isolationsschicht auf die erste elektrische Isolationsschicht (22),
- Bilden der zweiten Ebene elektrischer Leiter (26) in der zweiten elektrischen Isolationsschicht, was die elektrischen Verbindungen mit den elektrischen Leitern der ersten Ebene sicher stellt,
- Eliminierung der zweiten elektrischen Isolationsschicht,
- Eliminierung der ersten elektrischen Isolationsschicht (22), um die Teile der ersten elektrischen Isolationsschicht zu entfernen, die den Bereichen entsprechen, wo die elektrischen Leiter den geringen Abstand aufweisen, wobei die erste elektrische Isolationsschicht in den Bereichen belassen wird, wo der Abstand zwischen den elektrischen Leitern der ersten Ebene groß ist,
- Aufbringen des Materials mit einer elektrischen Permittivität von kleiner als 3 (27) auf die erhaltene Struktur, wobei dieses Aufbringen nicht den Raum zwischen elektrischen Leitern der ersten Ebene füllt, deren Abstand vorgesehen worden ist, um die Bildung von luftgefüllten oder leeren Hohlräumen (28) zu ermäglichen.

2. Verfahren nach Anspruch 1,
**dadurch gekennzeichnet, dass** das Aufbringen von Material mit elektrischer Permittivität kleiner als 3 die elektrischen Leiter der zweiten Ebene abdeckt, wobei das Verfahren nach dem Schritt des Aufbringens des Materials mit elektrischer Permittivität kleiner als 3 einen Planarisierungsschritt umfasst, um die elektrischen Leiter freizulegen.

3. Verfahren nach einem der Ansprüche 1 oder 2,
**dadurch gekennzeichnet, dass** die erste elektrische Isolationsschicht (22) eine Schicht aus einem Material ist, das ausgewählt ist aus SiO₂ und SiOF.

4. Verfahren nach einem der Ansprüche 1 oder 3,
**dadurch gekennzeichnet, dass** die zweite elektrische Isolationsschicht eine Schicht aus einem Material ist, das ausgewählt ist aus SiO₂ und SiOF.

5. Verfahren nach einem der Ansprüche 1 bis 4,
**dadurch gekennzeichnet**, das es das Aufbringen einer ersten Zwischenschicht aus einem isolierenden Material (21) auf dem Halbleiterbauteil (20) vor der Bildung der ersten Ebene elektrischer Leiter umfasst, und das Aufbringen einer zweiten Zwischenschicht (24) auf die erste Ebene elektrischer Leiter vor der Bildung der zweiten Ebene elektrischer Leiter.

6. Verfahren nach Anspruch 5,
**dadurch gekennzeichnet, dass** das isolierende Material der ersten Zwischenschicht (21) ausgewählt ist aus SiₓN_{y}, SiOₓN_{y} und SiC.

7. Verfahren nach einem der Ansprüche 5 oder 6,
**dadurch gekennzeichnet, dass** die zweite Zwischenschicht (24) aus einem Material besteht, das ausgewählt ist aus SiₓN_{y}, SiOₓN_{y} und SiC.

8. Verfahren nach einem der Ansprüche 5 bis 7,
**dadurch gekennzeichnet, dass** es nach der Eliminierung der zweiten elektrischen Isolationsschicht und vor dem Schritt der Eliminierung der ersten elektrischen Isolationsschicht (22) das Aufbringen einer Harz/Kunstharz-Schicht auf die Zwischenschicht umfasst, die auf die erste Ebene elektrischer Leiter aufgebracht ist, die Bildung einer Maske (29), ausgehend von der Harz/Kunstharz-Schicht, um die Eliminierung der ersten elektrischen Isolationsschicht (22) zu realisieren, die Eliminierung des Teils der Zwischenschicht (24), der auf der ersten Ebene elektrischer Leiter aufgebracht und nicht durch die Harz/Kunstharz-Maske maskiert ist, wobei der Schritt der Eliminierung der ersten elektrischen Isolationsschicht nun realisierk wird.

9. Verfahren nach einem der Ansprüche bis 8,
**dadurch gekennzeichnet, dass** die elektrischen Leiter der ersten Ebene elektrischer Leiter und die elektrischen Leiter der zweiten Ebene elektrischer Leiter aus Kupfer bestehen oder Kupfer umfassen.
